# EUROPEAN PATENT APPLICATION

(11) **EP 4 800 910 A1**
(43) Date of publication of application: **02.09.2026**
(21) Application number: 25160840.2
(22) Date of filing: 28.02.2025
(51) Int. Cl.: H02P 3/22

(54) **COMBINED INDUCTION-TYPE ELECTRICAL MACHINE AND BRAKING ARRANGEMENT WITH STATOR CURRENT CONTROL**

(71) Applicant: Volvo Truck Corporation, 405 08 Göteborg (SE)
(72) Inventor: LINDBERG, Johan, 415 24 GÖTEBORG (SE); LAINE, Leo, 414 84 GÖTEBORG (SE); STENBRATT, Ulf, 434 94 VALLDA (SE)
(74) Representative: Kransell & Wennborg KB

(57) **Abstract**

A combined induction-type electrical machine and braking arrangement (19) for use in a heavy vehicle (3), comprising a stator (23) coupled to a body (7) of the vehicle (3), the stator comprising stator windings; a rotor (25) coupled to at least one wheel (9) of the vehicle (3), the rotor comprising rotor conductors (31a-c; 41a-c); a current sensing arrangement (30) configured to sense induced current in at least one rotor conductor; a configuration switching arrangement (33) coupled to the current sensing arrangement (30) and the rotor conductors, and configured to switch from a first configuration, where the induced current experiences a first total resistance, to a second configuration, where it experiences a higher second total resistance, in response to a predefined first signal (49) from the current sensing arrangement (30); and a controller (29) configured to control the stator current to cause the induced current to result in the first signal.

## Description

### TECHNICAL FIELD

The disclosure relates generally to an electrical machine, and to a method of controlling the electrical machine. In particular aspects, the disclosure relates to a combined induction-type electrical machine and braking arrangement with stator current control. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Electrical commercial vehicles tend to use primarily regenerative braking instead of friction brakes to minimize energy consumption and thus maximize driving range. There are however situations where this is not possible due to limitations in the energy storage system (battery) due to high state-of-charge (SOC), high/low temperatures or other reasons.

One solution is to use the friction brakes. This however comes with other challenges, such as particle emissions, cost/downtime for maintenance, sizing of the friction brakes for this edge case, and additional noise.

It would be desirable to provide for reduced use of friction brakes.

### SUMMARY

According to a first aspect of the disclosure, there is provided a combined induction-type electrical machine and braking arrangement for use in a heavy vehicle, comprising: a stator configured to be coupled to a body of the vehicle, the stator comprising stator windings; a rotor configured to be coupled to at least one wheel of the vehicle, the rotor comprising rotor conductors; a current sensing arrangement configured to sense the induced current flowing through at least one rotor conductor of the rotor conductors; a configuration switching arrangement coupled to the current sensing arrangement and to the rotor conductors of the rotor and configured to switch from a first configuration in which induced current flowing through the rotor conductors experiences a first total resistance to a second configuration in which induced current flowing through the rotor conductors experiences a second total resistance, higher than the first total resistance, in response to receiving a predefined first signal from the current sensing arrangement; and a controller configured to control a stator current supplied to the stator windings in such a way that the induced current in the rotor conductors results in the first signal from the current sensing arrangement. The first aspect of the disclosure may seek to provide an induction machine that can be used both as a traction motor and as an electromagnetic brake. The present inventors have realized that subjecting the induced current flowing through the rotor conductors to a relatively low resistance provides for relatively efficient operation as a traction motor, and subjecting the induced current flowing through the rotor conductors to a relatively high resistance provides for relatively efficient operation as an electromagnetic brake. Hereby, more efficient electromagnetic braking can be achieved in a vehicle provided with the combined induction-type electrical machine and braking arrangement, which in turn allows for reduced use of a friction brake, providing for reduced maintenance costs, and emissions. Hereby, the vehicle may be equipped with a more compact friction brake system, or even completely without a friction brake system, enabling potential weight and cost savings. The inventors have further understood that it may be challenging to control switching between a first configuration in which induced current flowing through the rotor conductors experiences a first total resistance and a second configuration in which induced current flowing through the rotor conductors experiences a second total resistance, higher than the first total resistance during rotation of the rotor. Based on this understanding, the inventors have come to the realization that such switching can be controlled by providing a configuration switching arrangement configured to switch from the first configuration to the second configuration in response to receiving a predefined first signal from the current sensing arrangement, and a controller configured to control a stator current supplied to the stator windings in such a way that the induced current in the rotor conductors results in the predefined first signal from the current sensing arrangement. Controlling the switching on the rotor using control of the stator current eliminates the need for additional wired connections or wireless communication with the rotor, simplifying the system design and improving reliability. A technical benefit may include reducing wear and maintenance associated with slip rings or wireless signal transmission, as well as ensuring that switching can be performed dynamically without requiring mechanical actuators on the rotor.

The current sensing arrangement may be configured to generate the predefined first signal based on characteristics of the induced current in the rotor conductors. The controller may, for example, introduce a predefined modulation pattern in the stator current, which propagates through the machine and results in a corresponding variation in the induced rotor current. This variation may include changes in amplitude, frequency content, or transient behavior that can be reliably distinguished from normal operating conditions. The current sensing arrangement may process the sensed induced current and generate the predefined first signal when the sensed current meets predefined criteria, such as exceeding a threshold amplitude, matching a specific frequency range, or exhibiting a distinct temporal pattern.

Optionally, in some examples, including in at least one preferred example, the controller may be configured to generate a predefined first modulation pattern in a reactive current component of the stator current, selected to result in the first signal from the current sensing arrangement. A technical benefit may include enabling controlled switching with minimal disturbance to the rotational speed of the rotor and/or the torque provided by the combined induction-type electrical machine and braking arrangement. In particular, this may allow for smooth transitions between propulsion and braking modes while maintaining stability in the operation of the combined induction-type electrical machine and braking arrangement. Additionally, utilizing the reactive current component for switching control may reduce interference with the primary torque control of the combined induction-type electrical machine and braking arrangement, ensuring that propulsion and braking remain predictable and efficiently regulated.

Optionally, in some examples, including in at least one preferred example, the first modulation pattern may comprise a first sequence of current pulses. A technical benefit may include providing a distinct and easily recognizable signal for the current sensing arrangement, improving the reliability of the switching control. In particular, this may enhance the robustness of the system by ensuring that the switching event is triggered only in response to a well-defined modulation pattern, reducing the risk of unintended switching due to noise or fluctuations in the stator current.

Optionally, in some examples, including in at least one preferred example, the current sensing arrangement may comprise at least one current sensor arranged on the rotor to directly measure the induced current in at least one rotor conductor. A technical benefit may include enabling precise detection of the induced signal used to request the configuration switch. In particular, this may improve the reliability of the switching control by ensuring that the transition between motoring and braking modes is triggered only in response to a well-defined induced current, reducing the risk of unintended switching due to noise or other disturbances.

Optionally, in some examples, including in at least one preferred example, the current sensor may comprise a Rogowski coil arranged around the at least one rotor conductor. A technical benefit may include enabling contactless and highly accurate measurement of the induced current used to request the configuration switch. In particular, this may improve the reliability of the switching control by providing a precise and interference-resistant sensing method, ensuring that the switching event is triggered based on a well-defined induced current while minimizing the impact of electromagnetic noise and mechanical constraints. A Rogowski coil may be particularly well-suited for this application because it provides a contactless, non-intrusive means of measuring AC currents, including transient and high-frequency signals, without introducing significant electrical or mechanical load on the rotor. Since it does not require a magnetic core, it avoids saturation effects and maintains a linear response over a wide current range, ensuring precise measurement of the induced current used to request the configuration switch. Additionally, a Rogowski coil is inherently immune to DC offset and provides excellent noise rejection, which enhances the robustness of the switching control by minimizing the risk of erroneous switching events due to external disturbances.

Optionally, in some examples, including in at least one preferred example, the configuration switching arrangement may comprise a first set of switches and a second set of switches. The first configuration may be achieved by controlling the first set of switches to be conducting and the second set of switches to be non-conducting, thereby allowing the induced current to flow through a first current path defined by the first set of switches. The second configuration may be achieved by controlling the first set of switches to be non-conducting and the second set of switches to be conducting, thereby allowing the induced current to flow through a current path defined by the second set of switches. A technical benefit may include enabling efficient switching between traction and braking modes by dynamically adjusting the resistance experienced by the induced current. In particular, this may enhance braking performance while minimizing energy losses, contributing to improved vehicle control and a reduced reliance on friction brakes.

Suitable switches for the configuration switching arrangement may include high-power semiconductor devices such as insulated gate bipolar transistors (IGBTs), metal-oxide-semiconductor field-effect transistors (MOSFETs) designed for high-current applications, or thyristors such as gate turn-off thyristors (GTOs) and silicon-controlled rectifiers (SCRs). IGBTs may be particularly suitable due to their ability to handle high voltages and large currents with relatively low switching losses, making them well-suited for induction motor applications. Alternatively, GTOs or SCRs can be used in scenarios where robust operation under high-power conditions is required, particularly in heavy-duty vehicle applications where electromagnetic braking demands reliable and efficient current control.

Optionally, in some examples, including in at least one preferred example, the configuration switching arrangement may comprise a set of resistive elements. Each switch within the first set of switches may be arranged to short-circuit a corresponding resistive element of the set of resistive elements when controlled to be conducting, and each switch within the second set of switches may be arranged to allow current to flow through a corresponding resistive element of the set of resistive elements when controlled to be conducting. A technical benefit may include achieving two distinct current paths with different resistance levels without requiring twice the number of rotor conductors. In particular, this may enable the advantages of having dual sets of rotor conductors-such as the above-mentioned combination of improved motor efficiency and enhanced braking performance-without the added weight, material costs, and complexity associated with physically doubling the rotor conductors. The timing of the switching between the first and second configurations may be controlled in different ways depending on the desired performance characteristics. The controller may be configured to substantially simultaneously operate the first and second sets of switches, ensuring a direct transition between the configurations without an intermediate state. This may help to minimize transient effects and maintain consistent performance. Alternatively, a brief overlap or delay between the switching actions may be introduced to manage current flow dynamics, reduce electrical stress on components, or optimize braking smoothness. The choice of switching timing may depend on factors such as system design, operating conditions, and the specific requirements for traction and braking performance.

Optionally, in some examples, including in at least one preferred example, the set of resistive elements may comprise at least one resistive element for each rotor conductor of the rotor. Each switch of the first set of switches may be arranged to interrupt a corresponding rotor conductor of the rotor when controlled to be non-conducting, and each switch of the second set of switches may be arranged to allow induced current to flow through an interrupted rotor conductor of the rotor by providing a bypass current path through a corresponding resistive element of the set of resistive elements when controlled to be conducting. A technical benefit may include to allow selective modification of the effective rotor resistance without requiring additional winding structures. In particular, this may allow for an adaptable and space-efficient rotor design that enables efficient traction and braking performance while minimizing added weight and complexity in the rotor assembly.

Optionally, in some examples, including in at least one preferred example, the rotor may be a squirrel cage rotor, where each rotor conductor is provided in the form of a conducting bar extending between a first end ring and a second end ring. Each switch of the first set of switches may be arranged along a corresponding conducting bar. A technical benefit may include to allow selective modification of the rotor resistance while maintaining the robustness and simplicity of a squirrel cage rotor design. In particular, this may enable efficient switching between motoring and braking configurations without requiring significant changes to the fundamental rotor structure, ensuring compatibility with conventional manufacturing techniques and facilitating cost-effective implementation.

Optionally, in some examples, including in at least one preferred example, the rotor may comprise a first set of rotor conductors, each exhibiting a first rotor conductor resistance, and a second set of rotor conductors, each exhibiting a second rotor conductor resistance, higher than the first rotor conductor resistance. Each switch of the first set of switches may be arranged to interrupt a corresponding rotor conductor of the first set when controlled to be non-conducting, and each switch of the second set of switches may be arranged to interrupt a corresponding rotor conductor of the second set when controlled to be non-conducting. A technical benefit may include to allow selective modification of the rotor resistance by enabling distinct conductive paths with different resistance levels. In particular, this may improve thermal management by distributing heat generation more evenly across the rotor, reducing localized overheating, and enhancing the durability and reliability of the braking system while maintaining efficient control over traction and braking performance.

Optionally, in some examples, including in at least one preferred example, each rotor conductor of the first set of rotor conductors may be made of copper or aluminum, and each rotor conductor of the second set of rotor conductors may be made of iron or steel. A technical benefit may include to allow selective modification of the rotor resistance by leveraging the high electrical conductivity of copper or aluminum to minimize resistive losses during motoring operation while utilizing the higher resistivity of iron or steel to enhance braking performance. In particular, this may provide a well-balanced rotor design that optimizes both traction and braking efficiency without requiring additional external resistive components, ensuring a robust and efficient configuration for vehicle applications.

Optionally, in some examples, including in at least one preferred example, the rotor may be a squirrel cage rotor, where each rotor conductor of the first set of rotor conductors is provided in the form of a first conducting bar extending between a first end ring and a second end ring, and each rotor conductor of the second set of rotor conductors is provided in the form of a second conducting bar extending between the first end ring and the second end ring. Each switch of the first set of switches may be arranged along a corresponding first conducting bar, and each switch of the second set of switches may be arranged along a corresponding second conducting bar. A technical benefit may include to allow selective modification of the rotor resistance while maintaining compatibility with conventional squirrel cage rotor designs. In particular, this may enable efficient integration of distinct resistance characteristics for motoring and braking without requiring significant alterations to existing rotor manufacturing processes, facilitating cost-effective production while enhancing performance.

Optionally, in some examples, including in at least one preferred example, each switch of the first set of switches and each switch of the second set of switches may be a bi-stable switch configured to maintain its state without continuous power consumption after switching. A technical benefit may include to allow selective modification of the rotor resistance while reducing the energy required to operate the configuration switching arrangement. In particular, this may improve efficiency by eliminating the need for continuous actuation power, ensuring stable retention of the selected configuration without ongoing electrical input.

Optionally, in some examples, including in at least one preferred example, the configuration switching arrangement may be configured to switch from the second configuration to the first configuration in response to receiving a predefined second signal from the current sensing arrangement. The controller may be configured to control the stator current supplied to the stator windings in such a way that the induced current in the rotor conductors results in the second signal from the current sensing arrangement. A technical benefit may include to allow selective modification of the rotor resistance based on a controlled and predefined signal, ensuring reliable and precise triggering of the configuration switch. In particular, this may improve the robustness of the switching process by reducing susceptibility to unintended switching caused by noise or fluctuations in rotor current, thereby enhancing the overall reliability of the system.

Optionally, in some examples, including in at least one preferred example, the controller may be configured to generate a predefined second modulation pattern in a reactive current component of the stator current, selected to result in the second signal from the current sensing arrangement. A technical benefit may include to allow selective modification of the rotor resistance by enabling a contactless and efficient method for triggering the configuration switch. In particular, using a modulation pattern in the reactive current component allows the second signal to be provided substantially without affecting the rotational speed of the rotor, ensuring that the switching event can be reliably initiated without disrupting normal motoring or braking operation.

Optionally, in some examples, including in at least one preferred example, the combined induction-type electrical machine and braking arrangement according to examples of the first aspect may be comprised in a vehicle, further comprising a body and at least one wheel. The stator of the combined induction-type electrical machine and braking arrangement may be coupled to the body of the vehicle, and the rotor of the combined induction-type electrical machine and braking arrangement may be coupled to the at least one wheel. A technical benefit may include to allow selective modification of the rotor resistance to be utilized directly in a vehicle application, enabling efficient transitions between motoring and braking. In particular, this may improve energy efficiency and reduce reliance on friction brakes, contributing to lower maintenance costs and extended component lifespan.

According to a second aspect of the disclosure, there is provided a computer-implemented method comprising receiving a braking command for braking at least one wheel of a vehicle and controlling, in response to the braking command, the stator current supplied to the stator windings of the combined induction-type electrical machine and braking arrangement in such a way that the induced current in the rotor conductors results in the first signal from the current sensing arrangement of the combined induction-type electrical machine and braking arrangement according to the first aspect of the disclosure. The second aspect of the disclosure may seek to provide a control method that enables efficient and timely switching between motoring and braking modes. The present inventors have realized that dynamically adjusting the stator current to induce a predefined signal in the rotor conductors allows for precise triggering of the configuration switching arrangement without requiring direct electrical connections to the rotor. Hereby, more efficient electromagnetic braking can be achieved in a vehicle provided with the combined induction-type electrical machine and braking arrangement, which in turn allows for reduced use of a friction brake, providing for reduced maintenance costs and emissions. Hereby, the vehicle may be equipped with a more compact friction brake system, or even completely without a friction brake system, enabling potential weight and cost savings. The inventors have further understood that it may be challenging to control switching between a first configuration in which induced current flowing through the rotor conductors experiences a first total resistance and a second configuration in which induced current flowing through the rotor conductors experiences a second total resistance, higher than the first total resistance during rotation of the rotor, and have come to the realization that such switching can be controlled by adjusting the stator current in such a way that the induced current in the rotor conductors results in the first signal from the current sensing arrangement. Controlling the switching on the rotor using control of the stator current eliminates the need for additional wired connections or wireless communication with the rotor, simplifying the system design and improving reliability. A technical benefit may include reducing wear and maintenance associated with slip rings or wireless signal transmission, as well as ensuring that switching can be performed dynamically without requiring mechanical actuators on the rotor.

Optionally, in some examples, including in at least one preferred example, the method may further comprise receiving a propulsion command for propelling the at least one wheel of the vehicle and controlling, in response to the propulsion command, the stator current supplied to the stator windings of the combined induction-type electrical machine and braking arrangement in such a way that the induced current in the rotor conductors results in a predefined signal from the current sensing arrangement of the combined induction-type electrical machine and braking arrangement, wherein the configuration switching arrangement of the combined induction-type electrical machine and braking arrangement is configured to switch from the second configuration to the first configuration, in response to receiving the predefined second signal from the current sensing arrangement. A technical benefit may include to allow selective modification of the rotor resistance using stator current control not only for braking but also for transitioning back to motoring operation. In particular, this may ensure that the configuration switching arrangement can be controlled using the same signal-based approach in both directions, eliminating the need for additional sensors or actuators on the rotor while maintaining precise and reliable switching behavior.

According to a third aspect of the disclosure, there is provided a computer program product comprising program code for performing, when executed by processing circuitry comprised in the controller of the combined induction-type electrical machine and braking arrangement of the first aspect of the disclosure, the method of the second aspect of the disclosure.

According to a fourth aspect of the disclosure, there is provided a non-transitory computer-readable storage medium comprising instructions, which when executed by processing circuitry comprised in the controller of the combined induction-type electrical machine and braking arrangement of the first aspect of the disclosure, cause the processing circuitry to perform the method of the second aspect of the disclosure.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is an exemplary vehicle according to an example.
**FIG. 2** is an exemplary axle according to an example.
**FIG. 3** is an exemplary combined induction-type electrical machine and braking arrangement according to an example.
**FIG. 4A** is an exemplary rotor of the combined induction-type electrical machine and braking arrangement in FIG. 3 in a first configuration.
**FIG. 4B** is an exemplary rotor of the combined induction-type electrical machine and braking arrangement in FIG. 3 in a second configuration.
**FIG. 5A** is an exemplary rotor of the combined induction-type electrical machine and braking arrangement in FIG. 3 in a first configuration.
**FIG. 5B** is an exemplary rotor of the combined induction-type electrical machine and braking arrangement in FIG. 3 in a second configuration.
**FIG. 6** is an exemplary method according to an example.
**FIG. 7** is an exemplary modulation pattern according to an example.
**FIG. 8** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

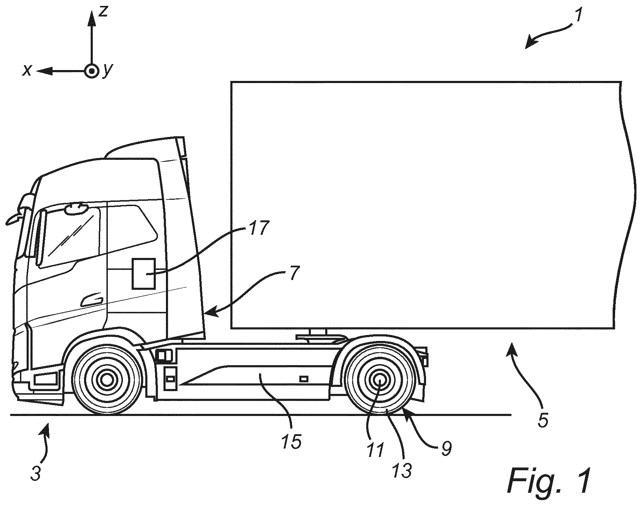

FIG. 1 illustrates an exemplary vehicle 3 according to an example. The vehicle 3 comprises a body 7 and at least one wheel 9. The wheel 9 is configured to rotate around a rotational axis 11 and is provided with a tire 13. The vehicle 3 further comprises a battery 15. The vehicle 3 also comprises a combined induction-type electrical machine and braking arrangement 19 (not shown in FIG. 1).

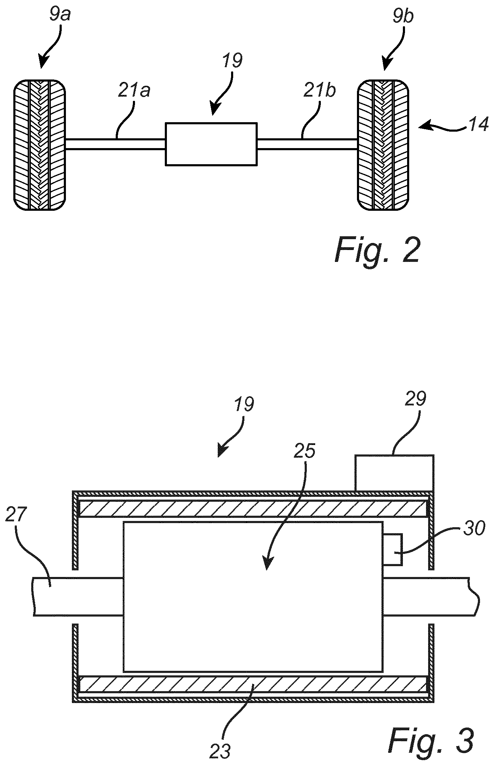

FIG. 2 illustrates an exemplary axle 14 according to an example. The axle 14 comprises a combined induction-type electrical machine and braking arrangement 19, arranged to propel and/or brake the wheels 9a-b via corresponding half shafts 21a-b. This configuration is merely an example, and variations are possible. There may be one combined induction-type electrical machine and braking arrangement 19 arranged and configured to propel and/or brake a larger or smaller number of wheels 9a-b. According to one example, the combined induction-type electrical machine and braking arrangement 19 may be connected to one or more wheels 9a-b via a transmission (not shown). According to another example, the combined induction-type electrical machine and braking arrangement 19 may be integrated into the wheel 9a-b.

FIG. 3 illustrates an exemplary combined induction-type electrical machine and braking arrangement 19 according to an example. The arrangement 19 comprises a stator 23 and a rotor 25. The rotor 25 is shown as including a shaft 27, which may be directly or indirectly coupled to at least one wheel 9a-b, such as via the half shafts 21a-b shown in FIG. 2. A configuration switching arrangement (not shown in FIG. 3) is controllable to switch between different configurations for the combined induction-type electrical machine and braking arrangement 19. The combined induction-type electrical machine and braking arrangement 19 further comprises a controller 29 configured to control the configuration switching arrangement 33. In this example, the combined induction-type electrical machine and braking arrangement 19 also includes a current sensing arrangement 30, which is configured to sense the induced current flowing through at least one rotor conductor of the rotor 25. The current sensing arrangement 30 is, in this example, mounted on the rotor 25, allowing direct measurement of the induced current.

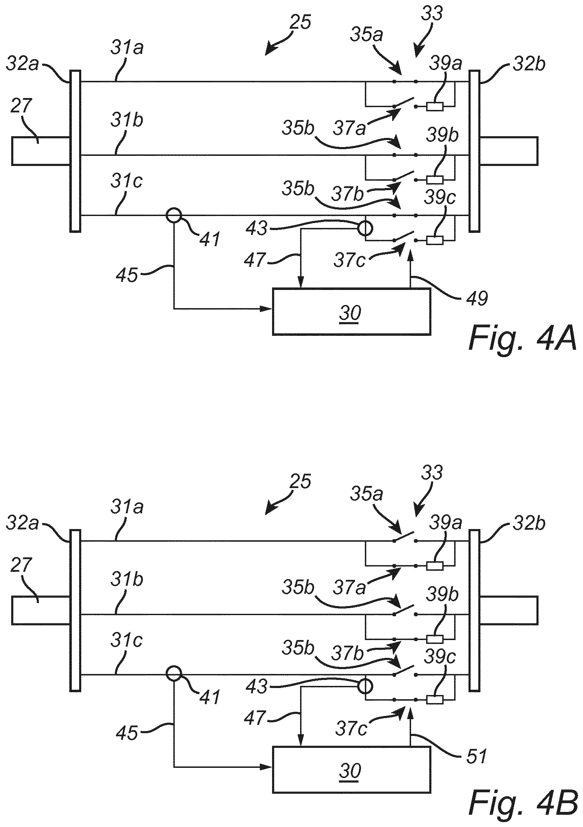

FIGS. 4A and 4B illustrate one example of a rotor 25 of the squirrel cage type, which may be comprised in the combined induction-type electrical machine and braking arrangement 19 shown in FIG. 3. The rotor 25 includes rotor conductors 31a-c extending between a first end ring 32a and a second end ring 32b. A configuration switching arrangement 33 is coupled to the rotor 25 and is controllable to switch between a first configuration and a second configuration. In the first configuration, the induced current flowing through the rotor conductors 31a-c experiences a first total resistance, which is relatively low and suitable for propulsion. In the second configuration, the induced current experiences a second total resistance, which is higher and suitable for braking.

FIG. 4A illustrates the rotor 25 in the first configuration for an example where the rotor 25 is of the squirrel cage type and comprises a set of resistive elements 39a-c. Each rotor conductor is provided in the form of a conducting bar 31a-c, made of a material with relatively low electrical resistance, such as copper or aluminum, extending between the first end ring 32a and the second end ring 32b. The configuration switching arrangement 33 comprises a first set of switches 35a-c and a second set of switches 37a-c. In the first configuration, each switch in the first set of switches 35a-c is controlled to be conducting, while each switch in the second set of switches 37a-c is controlled to be non-conducting. Hereby, each switch of the first set of switches 35a-c short-circuits a corresponding resistive element 39a-c, allowing the induced current to flow through a first current path defined by the conducting bars 31a-c with relatively low resistance, which is suitable for propulsion.

In this example, the rotor 25 further comprises a current sensing arrangement 30, which includes a first current sensor 41 arranged to measure the induced current in the first current path and a second current sensor 43 arranged to measure the induced current in the second current path. In FIG. 4A and FIG. 4B, the current sensing arrangement 30 is schematically shown as only sensing the currents in one first current path and one second current path. It should be noted that the current sensing arrangement 30 may be configured to sense the currents in other or additional current paths. The first current sensor 41 and the second current sensor 43 may be implemented as Rogowski coils, enabling contactless and accurate measurement of the induced current for both configurations. The current sensing arrangement 30 is further configured to generate a predefined first signal 49 based on the measured induced current. The predefined first signal 49 may be generated in response to detecting a predefined first pattern or modulation in the induced current, which may be introduced through control of the stator current. By generating the predefined first signal 49 only in response to a controlled and predefined first pattern or modulation, the current sensing arrangement 30 ensures precise and reliable triggering of the switching process, reducing the risk of unintended switching caused by noise or fluctuations in the rotor current.

FIG. 4B illustrates the rotor 25 in the second configuration for an example where the rotor 25 is of the squirrel cage type and comprises the set of resistive elements 39a-c. Each rotor conductor is provided in the form of a conducting bar 31a-c, made of a material with relatively low electrical resistance, such as copper or aluminum, extending between the first end ring 32a and the second end ring 32b. The configuration switching arrangement 33 comprises the first set of switches 35a-c and the second set of switches 37a-c. In the second configuration, each switch in the first set of switches 35a-c is controlled to be non-conducting, while each switch in the second set of switches 37a-c is controlled to be conducting. Hereby, each switch of the second set of switches 37a-c allows the induced current to flow through a corresponding resistive element 39a-c, providing a bypass current path through the resistive elements 39a-c. This results in a higher total resistance for the induced current, which is suitable for braking.

In this configuration, the current sensing arrangement 30 may continue to measure the induced current and may be configured to generate a predefined second signal 51 when detecting a predefined second pattern or modulation in the induced current, which may be different from the predefined first pattern or modulation. The predefined second signal 51 serves as a control input for the configuration switching arrangement 33, enabling a controlled transition back to the first configuration when required. The predefined second pattern or modulation in the induced current may be introduced through control of the stator current, ensuring that the switching process is triggered in a precise and reliable manner. This allows seamless operation between motoring and braking modes without the need for additional mechanical actuators or dedicated signal transmission components on the rotor.

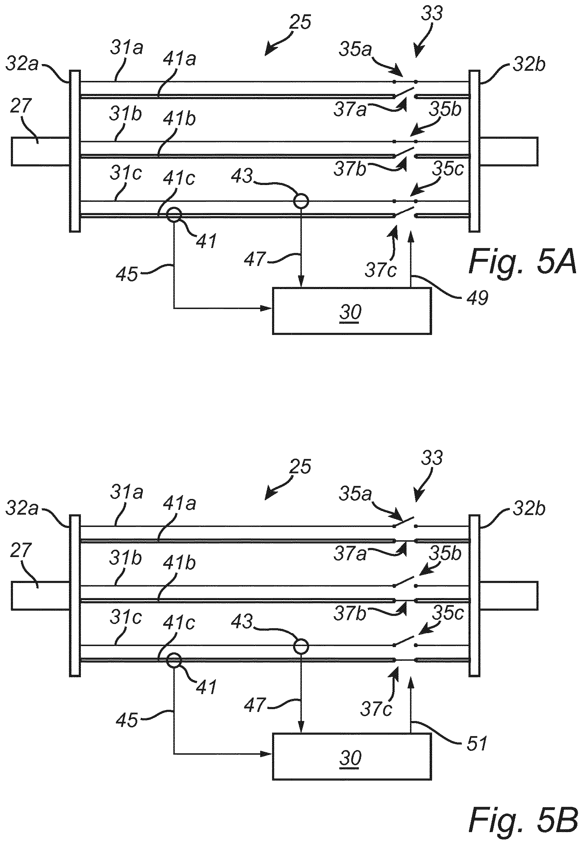

FIGS. 5A and 5B illustrate one example of a rotor 25 of the squirrel cage type, which may be comprised in the combined induction-type electrical machine and braking arrangement 19 shown in FIG. 3. The rotor 25 includes a first set of rotor conductors 31a-c and a second set of rotor conductors 41a-c, each extending between the first end ring 32a and the second end ring 32b. The configuration switching arrangement 33 is coupled to the rotor 25 and is controllable to switch between a first configuration and a second configuration. In the first configuration, the induced current flows through the first set of rotor conductors 31a-c, which are made of a material with relatively low electrical resistance, such as copper or aluminum, resulting in a first total resistance that is relatively low and suitable for propulsion. In the second configuration, the induced current flows through the second set of rotor conductors 41a-c, which are made of a material with higher electrical resistance, such as iron or steel, resulting in a second total resistance that is higher and suitable for braking.

FIG. 5A illustrates the rotor 25 in the first configuration for an example where the rotor 25 is of the squirrel cage type and comprises the first set of rotor conductors 31a-c and the second set of rotor conductors 41a-c. Each rotor conductor of the first set 31a-c is provided in the form of a first conducting bar extending between the first end ring 32a and the second end ring 32b and is made of a material with relatively low electrical resistance, such as copper or aluminum. Each rotor conductor of the second set 41a-c is provided in the form of a second conducting bar extending between the first end ring 32a and the second end ring 32b and is made of a material with higher electrical resistance, such as iron or steel. The configuration switching arrangement 33 comprises a first set of switches 35a-c and a second set of switches 37a-c. In the first configuration, each switch in the first set of switches 35a-c is controlled to be conducting, while each switch in the second set of switches 37a-c is controlled to be non-conducting. Hereby, the induced current flows through the first conducting bars 31a-c, resulting in a relatively low total resistance, which is suitable for propulsion.

In this example, the rotor 25 further comprises a current sensing arrangement 30, which includes a first current sensor 41 arranged to measure the induced current in the first set of rotor conductors and a second current sensor 43 arranged to measure the induced current in the second set of rotor conductors. In FIG. 5A and FIG. 5B, the current sensing arrangement 30 is schematically shown as only sensing the currents in one first current path and one second current path. It should be noted that the current sensing arrangement 30 may be configured to sense the currents in other or additional current paths. The first current sensor 41 and the second current sensor 43 may be implemented as Rogowski coils, enabling contactless and accurate measurement of the induced current for both configurations. The current sensing arrangement 30 is further configured to generate a predefined first signal 49 based on the measured induced current. The predefined first signal 49 may be generated in response to detecting a predefined first pattern or modulation in the induced current, which may be introduced through control of the stator current. By generating the predefined first signal 49 only in response to a controlled and predefined first pattern or modulation, the current sensing arrangement 30 ensures precise and reliable triggering of the switching process, reducing the risk of unintended switching caused by noise or fluctuations in the rotor current.

FIG. 5B illustrates the rotor 25 in the second configuration for an example where the rotor 25 is of the squirrel cage type and comprises the first set of rotor conductors 31a-c and the second set of rotor conductors 41a-c. Each rotor conductor of the first set 31a-c is provided in the form of a first conducting bar extending between the first end ring 32a and the second end ring 32b and is made of a material with relatively low electrical resistance, such as copper or aluminum. Each rotor conductor of the second set 41a-c is provided in the form of a second conducting bar extending between the first end ring 32a and the second end ring 32b and is made of a material with higher electrical resistance, such as iron or steel. The configuration switching arrangement 33 comprises the first set of switches 35a-c and the second set of switches 37a-c. In the second configuration, each switch in the first set of switches 35a-c is controlled to be non-conducting, while each switch in the second set of switches 37a-c is controlled to be conducting. Hereby, the induced current flows through the second conducting bars 41a-c, resulting in a higher total resistance, which is suitable for braking.

In this configuration, the current sensing arrangement 30 may continue to measure the induced current and may be configured to generate a predefined second signal 51 when detecting a predefined second pattern or modulation in the induced current, which may be different from the predefined first pattern or modulation. The predefined second signal 51 serves as a control input for the configuration switching arrangement 33, enabling a controlled transition back to the first configuration when required. The predefined second pattern or modulation in the induced current may be introduced through control of the stator current, ensuring that the switching process is triggered in a precise and reliable manner. This allows seamless operation between motoring and braking modes without the need for additional mechanical actuators or dedicated signal transmission components on the rotor.

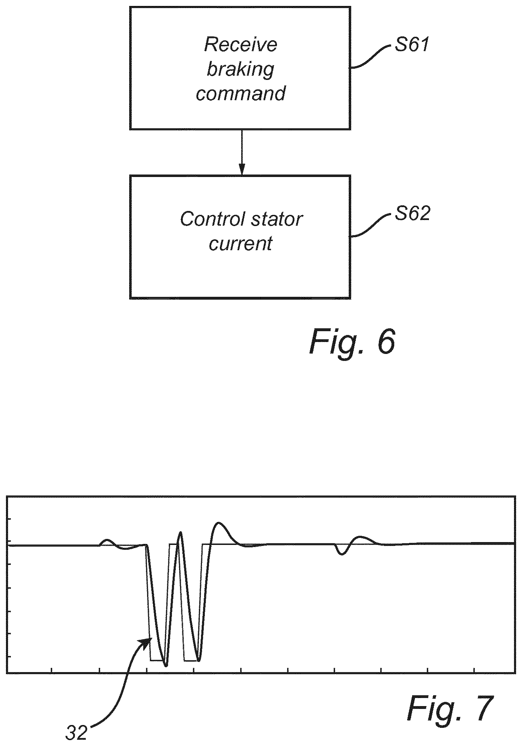

FIG. 6 illustrates an exemplary method according to an example. The method comprises receiving S61 a braking command for braking at least one wheel 9 of a vehicle 3. The method further comprises controlling S62, in response to the braking command, the stator current supplied to the stator windings of the combined induction-type electrical machine and braking arrangement 19 in such a way that the induced current in the rotor conductors 31a-c; 41a-c results in a predefined first signal 49 from the current sensing arrangement 30. The predefined first signal 49 triggers the configuration switching arrangement 33 to transition from the first configuration to the second configuration as described further above with reference to FIGS. 4A-B and FIGS. 5A-B.

FIG. 7 is an exemplary modulation pattern according to an example. The dotted line represents a conceptual representation of the predefined modulation pattern 32 in the reactive current component of the stator current, which is introduced through control of the stator current to generate a predefined first signal 49 or a predefined second signal 51. The solid line represents an estimation, based on circuit simulation, of the resulting induced rotor current. This induced rotor current is sensed by the current sensors shown in FIGS. 4A-B and FIGS. 5A-B, allowing the current sensing arrangement 30 to detect the modulation and trigger the configuration switching arrangement 33 accordingly.

The stator current may be controlled using a rotor-flux-oriented control system, where a modulation signal may be superimposed onto the reference rotor flux set-point to induce a predefined pattern in the rotor current. The amplitude, frequency, and duration of the modulation signal may be selected to ensure reliable detection while minimizing interference with normal operation. The amplitude should be sufficiently high to be distinguishable from background noise but not so large as to introduce significant deviations in rotor flux control. The frequency of the modulation may be chosen to be high enough to differentiate it from steady-state variations in rotor current but within a range that allows effective sensing by the current sensors. The duration of the modulation may be kept short, advantageously at most 10 milliseconds, to prevent prolonged disturbances while still providing a signal that can be robustly detected and processed. A person skilled in the art will, based on the information herein and her or his general knowledge and experience, be able to determine suitable amplitude, frequency, and duration values without undue burden. By appropriately selecting these parameters, the predefined first signal 49 and predefined second signal 51 may be generated with no or negligible impact on the control of the combined induction-type electrical machine and braking arrangement. The modulation signal may be designed to be short in duration, allowing it to avoid significant transients or disturbances in the machine's operation while still being reliably detectable by the current sensors in the rotor. The use of a predefined pattern in the reactive component of the stator current may enable precise switching control without requiring dedicated signal transmission to the rotor, providing for reliable operation.

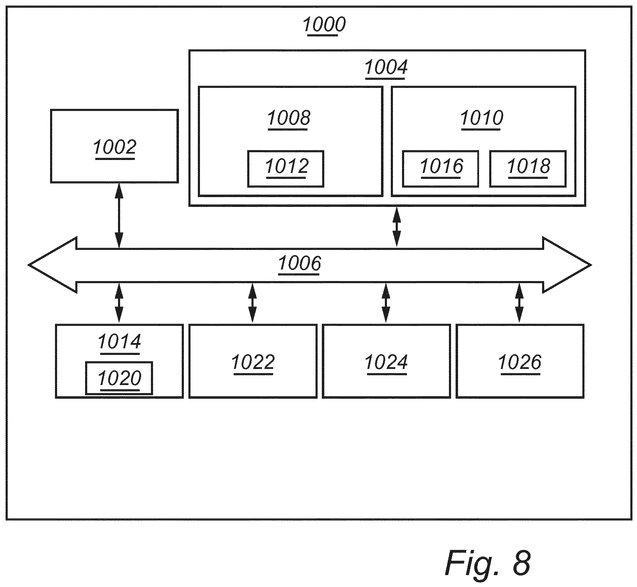

FIG. 8 is a schematic diagram of a computer system 1000 for implementing examples disclosed herein, such as for implementing examples of the controller 29 of the combined induction-type electrical machine and braking arrangement 19 according to examples. The computer system 1000 is adapted to execute instructions from a computer-readable medium to perform these and/or any of the functions or processing described herein. The computer system 1000 may be connected (e.g., networked) to other machines in a LAN, an intranet, an extranet, or the Internet, or by direct wired or wireless communication. While only a single device is illustrated, the computer system 1000 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 1000 may comprise at least one computing device or electronic device capable of including firmware, hardware, and/or executing software instructions to implement the functionality described herein. The computer system 1000 may include processing circuitry 1002 (e.g., processing circuitry including one or more processor devices or control units), a memory 1004, and a system bus 1006. The computer system 1000 may include at least one computing device having the processing circuitry 1002. The system bus 1006 provides an interface for system components including, but not limited to, the memory 1004 and the processing circuitry 1002. The processing circuitry 1002 may include any number of hardware components for conducting data or indication processing or for executing computer code stored in memory 1004. The processing circuitry 1002 may, for example, include a general-purpose processor, an application specific processor, a Digital indication Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 1002 may further include computer executable code that controls operation of the programmable device.

The system bus 1006 may be any of several types of bus structures that may further interconnect to a memory bus (with or without a memory controller), a peripheral bus, and/or a local bus using any of a variety of bus architectures. The memory 1004 may be one or more devices for storing data and/or computer code for completing or facilitating methods described herein. The memory 1004 may include database components, object code components, script components, or other types of information structure for supporting the various activities herein. Any distributed or local memory device may be utilized with the systems and methods of this description. The memory 1004 may be communicably connected to the processing circuitry 1002 (e.g., via a circuit or any other wired, wireless, or network connection) and may include computer code for executing one or more processes described herein. The memory 1004 may include non-volatile memory 1008 (e.g., read-only memory (ROM), erasable programmable read-only memory (EPROM), electrically erasable programmable read-only memory (EEPROM), etc.), and volatile memory 1010 (e.g., random-access memory (RAM)), or any other medium which can be used to carry or store desired program code in the form of machine-executable instructions or data structures and which can be accessed by a computer or other machine with processing circuitry 1002. A basic input/output system (BIOS) 1012 may be stored in the non-volatile memory 1008 and can include the basic routines that help to transfer information between elements within the computer system 1000.

The computer system 1000 may further include or be coupled to a non-transitory computer-readable storage medium such as the storage device 1014, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 1014 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 1014 and/or in the volatile memory 1010, which may include an operating system 1016 and/or one or more program modules 1018. All or a portion of the examples disclosed herein may be implemented as a computer program 1020 stored on a transitory or non-transitory computer-usable or computer-readable storage medium (e.g., single medium or multiple media), such as the storage device 1014, which includes complex programming instructions (e.g., complex computer-readable program code) to cause the processing circuitry 1002 to carry out actions described herein. Thus, the computer-readable program code of the computer program 1020 can comprise software instructions for implementing the functionality of the examples described herein when executed by the processing circuitry 1002. In some examples, the storage device 1014 may be a computer program product (e.g., readable storage medium) storing the computer program 1020 thereon, where at least a portion of a computer program 1020 may be loadable (e.g., into a processor) for implementing the functionality of the examples described herein when executed by the processing circuitry 1002. The processing circuitry 1002 may serve as a controller or control system for the computer system 1000 that is to implement the functionality described herein.

The computer system 1000 may include an input device interface 1022 configured to receive input and selections to be communicated to the computer system 1000 when executing instructions, such as from a keyboard, mouse, touch-sensitive surface, etc. Such input devices may be connected to the processing circuitry 1002 through the input device interface 1022 coupled to the system bus 1006 but can be connected through other interfaces, such as a parallel port, an Institute of Electrical and Electronic Engineers (IEEE) 1394 serial port, a Universal Serial Bus (USB) port, an IR interface, and the like. The computer system 1000 may include an output device interface 1024 configured to forward output, such as to a display, a video display unit (e.g., a liquid crystal display (LCD) or a cathode ray tube (CRT)). The computer system 1000 may include a communications interface 1026 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A combined induction-type electrical machine and braking arrangement for use in a heavy vehicle, comprising: a stator configured to be coupled to a body of the vehicle, the stator comprising stator windings; a rotor configured to be coupled to at least one wheel of the vehicle, the rotor comprising rotor conductors; a current sensing arrangement configured to sense the induced current flowing through at least one rotor conductor of the rotor conductors; a configuration switching arrangement coupled to the current sensing arrangement and to the rotor conductors of the rotor and configured to switch from a first configuration in which induced current flowing through the rotor conductors experiences a first total resistance to a second configuration in which induced current flowing through the rotor conductors experiences a second total resistance, higher than the first total resistance, in response to receiving a predefined first signal from the current sensing arrangement; and a controller configured to control a stator current supplied to the stator windings in such a way that the induced current in the rotor conductors results in the first signal from the current sensing arrangement.

Example 2: The combined induction-type electrical machine and braking arrangement of Example 1, wherein the controller is configured to generate a predefined first modulation pattern in a reactive current component of the stator current, selected to result in the first signal from the current sensing arrangement.

Example 3: The combined induction-type electrical machine and braking arrangement of Example 2, wherein the first modulation pattern comprises a first sequence of current pulses.

Example 4: The combined induction-type electrical machine and braking arrangement of any of Examples 1-3, wherein the current sensing arrangement comprises at least one current sensor arranged on the rotor to directly measure the induced current in at least one rotor conductor.

Example 5: The combined induction-type electrical machine and braking arrangement of Example 4, wherein the current sensor comprises a Rogowski coil arranged around the at least one rotor conductor.

Example 6: The combined induction-type electrical machine and braking arrangement of any of Examples 1-5, wherein the configuration switching arrangement comprises a first set of switches and a second set of switches, the first configuration is achieved by controlling the first set of switches to be conducting and the second set of switches to be non-conducting, thereby allowing the induced current to flow through a first current path defined by the first set of switches, and the second configuration is achieved by controlling the first set of switches to be non-conducting and the second set of switches to be conducting, thereby allowing the induced current to flow through a current path defined by the second set of switches.

Example 7: The combined induction-type electrical machine and braking arrangement of Example 6, wherein the configuration switching arrangement comprises a set of resistive elements, each switch of the first set of switches is arranged to short-circuit a corresponding resistive element of the set of resistive elements when controlled to be conducting, and each switch of the second set of switches is arranged to allow current to flow through a corresponding resistive element of the set of resistive elements when controlled to be conducting.

Example 8: The combined induction-type electrical machine and braking arrangement of Example 7, wherein the set of resistive elements comprises at least one resistive element for each rotor conductor of the rotor, each switch of the first set of switches is arranged to interrupt a corresponding rotor conductor of the rotor when controlled to be non-conducting, and each switch of the second set of switches is arranged to allow induced current to flow through an interrupted rotor conductor of the rotor by providing a bypass current path through a corresponding resistive element of the set of resistive elements when controlled to be conducting.

Example 9: The combined induction-type electrical machine and braking arrangement of any of Examples 6-8, wherein the rotor is a squirrel cage rotor, where each rotor conductor is provided in the form of a conducting bar extending between a first end ring and a second end ring, and each switch of the first set of switches is arranged along a corresponding conducting bar.

Example 10: The combined induction-type electrical machine and braking arrangement of Example 6, wherein the rotor comprises a first set of rotor conductors, each exhibiting a first rotor conductor resistance, and a second set of rotor conductors, each exhibiting a second rotor conductor resistance, higher than the first rotor conductor resistance, each switch of the first set of switches is arranged to interrupt a corresponding rotor conductor of the first set of rotor conductors when controlled to be non-conducting, and each switch of the second set of switches is arranged to interrupt a corresponding rotor conductor of the second set of rotor conductors when controlled to be non-conducting.

Example 11: The combined induction-type electrical machine and braking arrangement of Example 10, wherein each rotor conductor of the first set of rotor conductors is made of copper or aluminum, and each rotor conductor of the second set of rotor conductors is made of iron or steel.

Example 12: The combined induction-type electrical machine and braking arrangement of Example 10 or 11, wherein the rotor is a squirrel cage rotor, where each rotor conductor of the first set of rotor conductors is provided in the form of a first conducting bar extending between a first end ring and a second end ring, and each rotor conductor of the second set of rotor conductors is provided in the form of a second conducting bar extending between the first end ring and the second end ring, each switch of the first set of switches is arranged along a corresponding first conducting bar, and each switch of the second set of switches is arranged along a corresponding second conducting bar.

Example 13: The combined induction-type electrical machine and braking arrangement of any of Examples 6-11, wherein each switch of the first set of switches and each switch of the second set of switches is a bi-stable switch configured to maintain its state without continuous power consumption after switching.

Example 14: The combined induction-type electrical machine and braking arrangement of any of Examples 1-13, wherein the configuration switching arrangement is configured to switch from the second configuration to the first configuration, in response to receiving a predefined second signal from the current sensing arrangement, and the controller is configured to control the stator current supplied to the stator windings in such a way that the induced current in the rotor conductors results in the second signal from the current sensing arrangement.

Example 15: The combined induction-type electrical machine and braking arrangement of Example 14, wherein the controller is configured to generate a predefined second modulation pattern in a reactive current component of the stator current, selected to result in the second signal from the current sensing arrangement.

Example 16: A vehicle comprising a body, at least one wheel, and the combined induction-type electrical machine and braking arrangement of any of Examples 1-15, wherein the stator of the combined induction-type electrical machine and braking arrangement is coupled to the body of the vehicle, and the rotor of the combined induction-type electrical machine and braking arrangement is coupled to the at least one wheel.

Example 17: A computer-implemented method, comprising receiving a braking command for braking at least one wheel of a vehicle, and controlling, in response to the braking command, the stator current supplied to the stator windings of the combined induction-type electrical machine and braking arrangement of any of Examples 1-15 in such a way that the induced current in the rotor conductors results in the first signal from the current sensing arrangement of the combined induction-type electrical machine and braking arrangement of any of Examples 1-15.

Example 18: The method of Example 17, comprising receiving a propulsion command for propelling the at least one wheel of the vehicle, and controlling, in response to the propulsion command, the stator current supplied to the stator windings of the combined induction-type electrical machine and braking arrangement of any of Examples 1-15 in such a way that the induced current in the rotor conductors results in a predefined second signal from the current sensing arrangement of the combined induction-type electrical machine and braking arrangement of any of Examples 1-15, wherein the configuration switching arrangement of the combined induction-type electrical machine and braking arrangement is configured to switch from the second configuration to the first configuration, in response to receiving the predefined second signal from the current sensing arrangement.

Example 19: A computer program product comprising program code for performing, when executed by processing circuitry comprised in the controller of the combined induction-type electrical machine and braking arrangement of any of Examples 1-15, the method of Example 17 or 18.

Example 20: A non-transitory computer-readable storage medium comprising instructions, which when executed by processing circuitry comprised in the controller of the combined induction-type electrical machine and braking arrangement of any of Examples 1-15, cause the processing circuitry of the controller to perform the method of Example 17 or 18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A combined induction-type electrical machine and braking arrangement (19) for use in a heavy vehicle (3), comprising:
a stator (23) configured to be coupled to a body (7) of the vehicle (3), the stator comprising stator windings;
a rotor (25) configured to be coupled to at least one wheel (9) of the vehicle (3), the rotor (25) comprising rotor conductors (31a-c; 41a-c);
a current sensing arrangement (30) configured to sense the induced current flowing through at least one rotor conductor of the rotor conductors;
a configuration switching arrangement (33) coupled to the current sensing arrangement (30) and to the rotor conductors (31a-c; 41a-c) of the rotor (25) and configured to switch from a first configuration in which induced current flowing through the rotor conductors (31a-c; 41a-c) experiences a first total resistance to a second configuration in which induced current flowing through the rotor conductors (31a-c; 41a-c) experiences a second total resistance, higher than the first total resistance, in response to receiving a predefined first signal (49) from the current sensing arrangement (30); and
a controller (29) configured to control a stator current supplied to the stator windings in such a way that the induced current in the rotor conductors (31a-c; 41a-c) results in the first signal from the current sensing arrangement (30).

2. The combined induction-type electrical machine and braking arrangement (19) of claim 1, wherein the controller (29) is configured to generate a predefined first modulation pattern (32) in a reactive current component of the stator current, selected to result in the first signal from the current sensing arrangement (30).

3. The combined induction-type electrical machine and braking arrangement (19) of claim 2, wherein the first modulation pattern (32) comprises a first sequence of current pulses.

4. The combined induction-type electrical machine and braking arrangement (19) of any of claims 1-3, wherein the current sensing arrangement (30) comprises at least one current sensor (41, 43) arranged on the rotor (25) to directly measure the induced current in at least one rotor conductor (31a-c; 41a-c).

5. The combined induction-type electrical machine and braking arrangement (19) of claim 4, wherein the current sensor (41, 43) comprises a Rogowski coil arranged around the at least one rotor conductor (31a-c; 41a-c).

6. The combined induction-type electrical machine and braking arrangement (19) of any of claims 1-5, wherein:
the configuration switching arrangement (33) comprises a first set of switches (35a-c) and a second set of switches (37a-c);
the first configuration is achieved by controlling the first set of switches (35a-c) to be conducting and the second set of switches (37a-c) to be non-conducting, thereby allowing the induced current to flow through a first current path defined by the first set of switches (35a-c); and
the second configuration is achieved by controlling the first set of switches (35a-c) to be non-conducting and the second set of switches (37a-c) to be conducting, thereby allowing the induced current to flow through a current path defined by the second set of switches (37a-c).

7. The combined induction-type electrical machine and braking arrangement (19) of claim 6, wherein:
the configuration switching arrangement (33) comprises a set of resistive elements (39a-c);
each switch of the first set of switches (35a-c) is arranged to short-circuit a corresponding resistive element (39a-c) of the set of resistive elements when controlled to be conducting; and
each switch of the second set of switches (37a-c) is arranged to allow current to flow through a corresponding resistive element (39a-c) of the set of resistive elements when controlled to be conducting.

8. The combined induction-type electrical machine and braking arrangement (19) of claim 7, wherein:
the set of resistive elements (39a-c) comprises at least one resistive element for each rotor conductor (31a-c; 43a-c) of the rotor (25);
each switch of the first set of switches (35a-c) is arranged to interrupt a corresponding rotor conductor (31a-c; 43a-c) of the rotor (25) when controlled to be non-conducting; and
each switch of the second set of switches (37a-c) is arranged to allow induced current to flow through an interrupted rotor conductor (31a-c; 43a-c) of the rotor (25) by providing a bypass current path through a corresponding resistive element of the set of resistive elements (39a-c) when controlled to be conducting.

9. The combined induction-type electrical machine and braking arrangement (19) of any of claims 6-8, wherein:
the rotor (25) is a squirrel cage rotor, where each rotor conductor is provided in the form of a conducting bar (31a-c) extending between a first end ring (32a) and a second end ring (32b); and
each switch of the first set of switches (35a-c) is arranged along a corresponding conducting bar (31a-c).

10. The combined induction-type electrical machine and braking arrangement (19) of claim 6, wherein:
the rotor (25) comprises a first set of rotor conductors (31a-c), each exhibiting a first rotor conductor resistance, and a second set of rotor conductors (41a-c), each exhibiting a second rotor conductor resistance, higher than the first rotor conductor resistance;
each switch of the first set of switches (35a-c) is arranged to interrupt a corresponding rotor conductor of the first set of rotor conductors (31a-c) when controlled to be non-conducting; and
each switch of the second set of switches (37a-c) is arranged to interrupt a corresponding rotor conductor of the second set of rotor conductors (41a-c) when controlled to be non-conducting.

11. The combined induction-type electrical machine and braking arrangement (19) of claim 10, wherein:
the rotor (25) is a squirrel cage rotor, where each rotor conductor of the first set of rotor conductors (31a-c) is provided in the form of a first conducting bar extending between a first end ring (32a) and a second end ring (32b), and each rotor conductor of the second set of rotor conductors (41a-c) is provided in the form of a second conducting bar extending between the first end ring (32a) and the second end ring (32b);
each switch of the first set of switches (35a-c) is arranged along a corresponding first conducting bar; and
each switch of the second set of switches (37a-c) is arranged along a corresponding second conducting bar.

12. The combined induction-type electrical machine and braking arrangement (19) of any of claims 1-11, wherein:
the configuration switching arrangement (33) is configured to switch from the second configuration to the first configuration, in response to receiving a predefined second signal from the current sensing arrangement (30); and
the controller (29) is configured to control the stator current supplied to the stator windings in such a way that the induced current in the rotor conductors (31a-c; 41a-c) results in the second signal from the current sensing arrangement (30).

13. A vehicle (3) comprising:
a body (7);
at least one wheel (9); and
the combined induction-type electrical machine and braking arrangement (19) of any of claims 1-12,
wherein the stator (23) of the combined induction-type electrical machine and braking arrangement (19) is coupled to the body (7) of the vehicle (3), and the rotor (25) of the combined induction-type electrical machine and braking arrangement (19) is coupled to the at least one wheel (9).

14. A computer-implemented method, comprising:
receiving (S61) a braking command for braking at least one wheel (9) of a vehicle (3);
controlling (S62), in response to the braking command, the stator current supplied to the stator windings of the combined induction-type electrical machine and braking arrangement (19) of any of claims 1-12 in such a way that the induced current in the rotor conductors (31a-c; 41a-c) results in the first signal from the current sensing arrangement (30) of the combined induction-type electrical machine and braking arrangement (19) of any of claims 1-12.

15. A computer program product comprising program code for performing, when executed by processing circuitry comprised in the controller (29) of the combined induction-type electrical machine and braking arrangement (19) of any of claims 1-12, the method of claim 14.
